(19) Europäisches Patentamt

European Patent Office

Office européen des brevets

(11) Publication number: **0 184 757 B1**

## (12) EUROPEAN PATENT SPECIFICATION

(45) Date of publication of patent specification: **17.04.91**  (51) Int. Cl.⁵: **F16C 33/04**, C23C 16/34, G02B 26/10

(21) Application number: **85115310.6**

(22) Date of filing: **03.12.85**

(54) Frictional member and method of surface treating to obtain the same.

(30) Priority: **07.12.84 JP 258522/84**

(43) Date of publication of application:
**18.06.86 Bulletin 86/25**

(45) Publication of the grant of the patent:
**17.04.91 Bulletin 91/16**

(84) Designated Contracting States:
**DE FR GB NL**

(56) References cited:
**GB-A- 1 310 526**

**JOURNAL OF THE ELECTROCHEMICAL SOCI-
ETY, vol. 128, no. 7, July 1981, pages
1555-1563, Manchester, New Hampshire, US;
H. DUN et al.: "Mechanisms of plasma-
enhanced silicon nitride deposition using
SiH4/N2 mixture"**

**EXTENDED ABSTRACTS, vol. 84, no. 1, May
1984, pages 157-158, Pennington, New York,
US; D.M. CHEN et al.: "Plasma-deposited sili-
con nitride films for GaAs annealing encap-
sulation"**

(73) Proprietor: **KABUSHIKI KAISHA TOSHIBA
72, Horikawa-cho Saiwai-ku
Kawasaki-shi Kanagawa-ken 210(JP)**

(72) Inventor: **Suzuki, Katsumi c/o Patent Division
KABUSHIKI KAISHA TOSHIBA 1-1 Shibaura
1-chome
Minato-ku Tokyo 105(JP)**

(74) Representative: **Henkel, Feiler, Hänzel & Part-
ner
Möhlstrasse 37
W-8000 München 80(DE)**

Rank Xerox (UK) Business Services

## Description

This invention relates to a frictional member, in high speed frictional contact, such as a shaft or a bearing of a polygonal mirror for a high speed scanner of a semiconductor laser beam printer, and a method of surface treatment to obtain such a frictional member.

Polygonal mirrors rotating at as high a speed as 10,000 to 20,000 rpm are used for the high-speed scanning operation of semiconductor laser printers. Heretofore, mechanical support mechanisms have been used for the shaft and bearing of such polygonal mirrors. Where a semiconductor laser is used for a printer, however, a resolution of 40 to 70 $\mu$m is required with a spot diameter of 30 to 60 $\mu$m. The amount of play between the shaft and bearing increases when the mirror rotates at high speed, and mechanical wear of the bearing due to rotation over a long period of time have long been serious problems.

To solve these problems, dynamic air stream bearing systems for supporting a shaft with an air stream have been proposed and are in the stage of practical use. In such a dynamic air stream bearing system, the shaft and bearing are separated by an air stream, as a spacing medium, at the time of high-speed rotation at 10,000 to 20,000 rpm. For this reason, the two parts, i.e., shaft and bearing, are not worn during their relative rotation. The two parts, however, are in direct contact with each other at the time of the start and end of rotation. To prevent wear on either of these two occasions, super-hard steel with a Vickers hardness of 1,800 is used for the contacting portions. This super-hard steel, however, is high in price. In addition, because of its extreme hardness its processibility, when high precision is required, is inferior to other metals. The yield is particularly inferior when the steel is used for a shaft or bearing whose degree of precision is that required in a laser printer that of +2 to 4 $\mu$m. GB-A-1 310 526 discloses a gas-lubricated bearing wherein one of the two opposed bearing-surfaces is formed of or coated with the very hard, corrosion and wear resistant and low dense silicon carbide and the other is formed of another carbide.

In light of these circumstances this invention has, as its object, to provide both a member for use under conditions of high speed and friction, which is inexpensive, has excellent resistance to wear and equally good close contact properties, and is equal to the demands of mass production, and a method of surface treatment through which to obtain such a member.

As a means of achieving the stated object, the feature of this invention resides in a method of surface treatment in which a portion of a member subject to high-speed friction is surface treated with an amorphous silicon nitride film formed through glow discharge of a gas containing Si and a gas containing N, the amorphous silicon nitride film containing no chains of Si-$H_2$ or Si-H.

This invention can be more fully understood from the following detailed description when taken in conjunction with the accompanying drawings, in which:

Fig. 1 is a schematic side view showing a glow discharge apparatus for producing a frictional member with a deposited, hydrogen-containing, amorphous silicon nitride film;

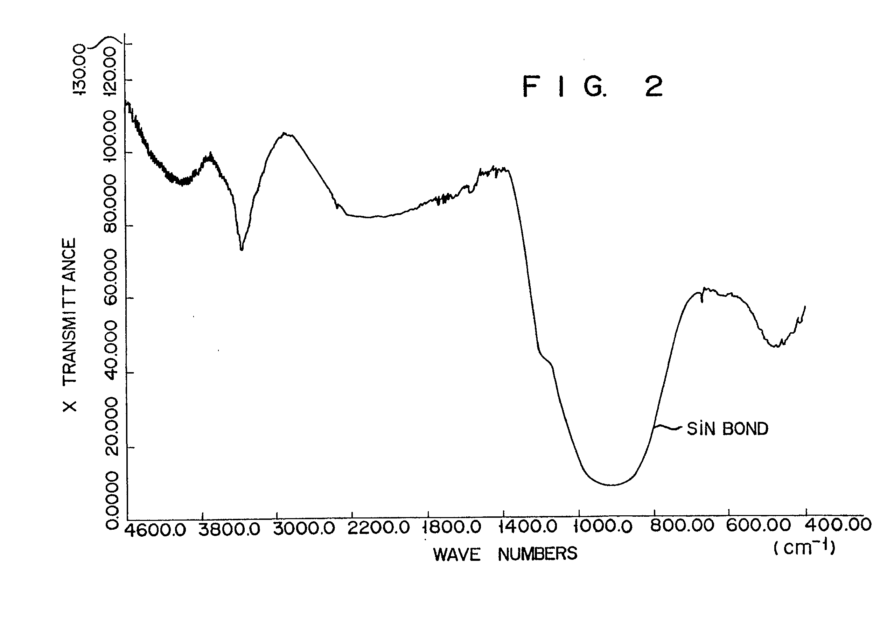

Fig. 2 is a graph showing the result of the measurement of the IR of the hydrogen-containing amorphous silicon nitride film;

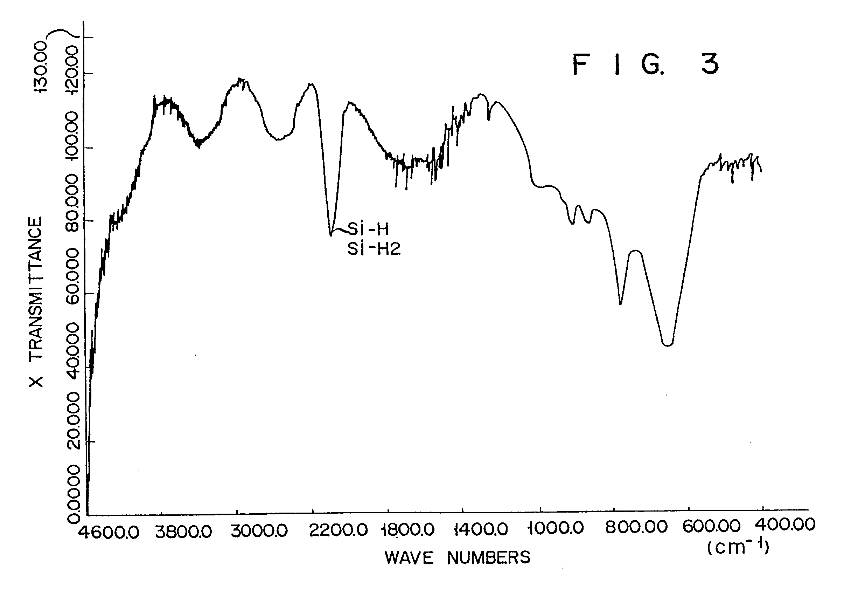

Fig. 3 is a graph showing the result of the measurement of the IR of a SiC film formed through glow discharge of $SiH_4$ gas and $CH_4$ gas; and

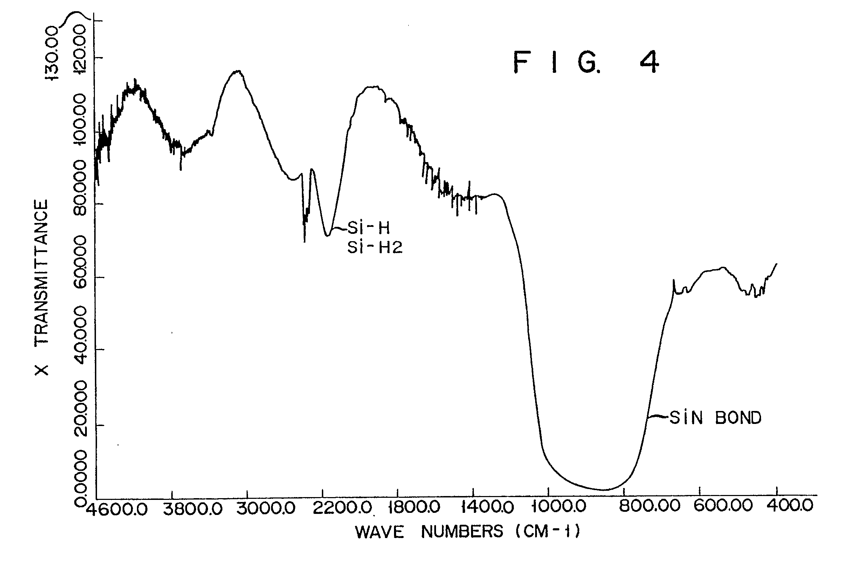

Fig. 4 is a graph showing the result of the measurement of the IR of a hydrogen-containing, amorphous silicon nitride film formed through glow discharge of $SiH_4$ gas and $N_2$ gas supplied at a flow ratio of 1 : 6 or below.

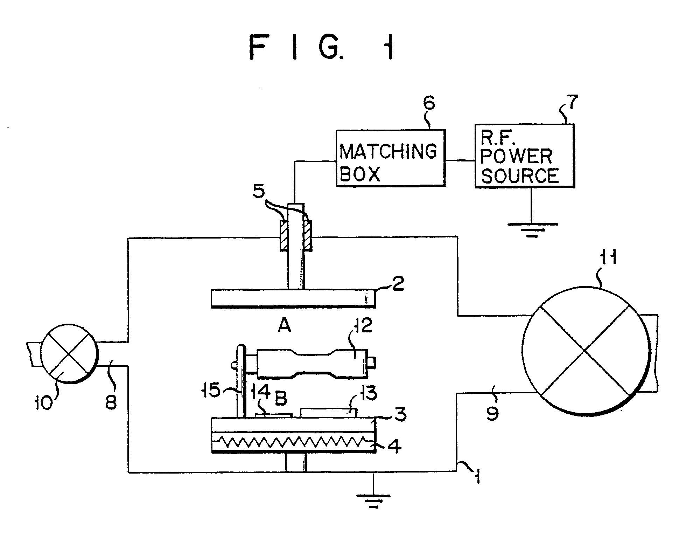

The frictional member and method of surface treatment to obtain the same, embodying the invention, will now be described with reference to the drawings accompanying the invention. Fig. 1 shows an apparatus for carrying out the method of surface treatment to obtain a frictional member according to an embodiment of the invention. Reference numeral 1 designates a grounded reaction vessel. Reaction vessel 1 accommodates electrode 2, to which high frequency power is supplied. Support 3 is disposed below and facing electrode 2, and heater 4 is disposed below support 3. Electrode 2 is connected to high frequency power source 7 through matching box 6. High frequency power source 7 supplies power at the frequency required for plasma discharge decomposition. Matching box 6, consisting of an LC circuit for matching the high frequency power, is provided outside reaction vessel 1 and insulated from the same by insulating material 5, e.g., Teflon.

Reference numeral 8 designates a gas supply tube, numeral 9 an exhausting tube, and numerals 10 and 11 valves.

The apparatus is used as a glow discharge apparatus. An operation of the apparatus will now be described in connection with surface treating a shaft 12 of a polygonal mirror with an amorphous SiN film which contains only a slight amount of H (i.e., a hydrogen-containing amorphous silicon film which contains N).

First, reaction vessel 1 is evacuated to a vacuum degree of 10 torr by opening valve 11 and operating a mechanical booster pump and a rotary pump (these pumps are not shown). At this time, polygonal mirror shaft 12, which is made of super-hard steel, is held, together with CORNING 7059 glass 13 and Si wafer 14, over support 3 and heated to a temperature of 250° C by heater 4.

Subsequently, valve 10 is opened, and $SiH_4$ gas and $N_2$ gas are supplied at 30 and 300 SCCM, respectively, into evacuated reaction vessel 1 through gas flow controllers (not shown). The gas pressure in reaction vessel 1 is set to 0.4 torr through control of valve 11.

Thereafter, power source 7, which supplies power at a radio frequency of 13.36 MHz, is turned on to supply power of 300 W to electrode 2. As a result, plasma of $SiH_4$ and $N_2$ gases is produced between electrode 2 and support 3. Formation of a hydrogen-containing, amorphous silicon nitride film is thus started. At this time, shaft 12 is held at a position substantially midway between electrode 2 and support 3 through adjustment of holder 15, so that plasma is provided not only on the side of shaft 12 nearest electrode 2 (i.e., the zone labeled A), but also on the side nearest support 3 (i.e., the zone labeled B).

The gases are supplied for about one hour to form the hydrogen-containing silicon nitride film to a thickness of about 2 µm. Then, power source 7 is turned off, and valve 10 is closed to discontinue the supply of the $SiH_4$ and $N_2$ gases. Similarly, heater 4 is de-energized.

Reaction vessel 1 is once again exhausted to 10 torr, with valve 11 held open for a continuous period of time. Then, valve 10 reopened to supply $N_2$ gas for 30 minutes to purge the residual $SiH_4$ gas. Valves 10 and 11 are then closed and reaction vessel 1 opened. Shaft 12, CORNING 7059 glass 13 and Si wafer 14 are then taken out into the atmosphere.

Experiments prove that a hydrogen-containing amorphous silicon nitride film is formed on the surface of shaft 12 by the above process, and that the film thus formed neither cracks nor separates when it undergoes a sudden change in temperature. It is confirmed from measurement of the infrared absorption of the Si wafer that the hydrogen-containing amorphous silicon nitride film thus formed by the apparatus shown in Fig. 1 is free from chains of Si-H and Si-H$_2$.

Further, the optical band gap of the hydrogen-containing amorphous silicon nitride film formed on the CORNING 7059 glass 13 is measured as 2.8 eV, confirming that a large amount of N atoms are introduced into the hydrogen-containing, amorphous silicon nitride film thus formed.

The optical band gap increases as more N atoms are introduced into the Si. The optical band gap of the amorphous silicon (a-Si) film, which is obtained through glow discharge of the solitary

$SiH_4$, lies in the range of 1.68 to 1.71 eV.

Polygonal mirror shaft 12, thus surface treated with hydrogen-containing amorphous silicon nitride film containing only a slight amount of H, was subjected to a running test for about 20,000 hours, in which rotation at 20,000 rpm was repeatedly started and stopped in a 60 minute mode. Results confirmed that the hydrogen-containing amorphous silicon nitride film was not in anyway affected, exhibiting, as it did, no signs of cracking or separation or any trace of scars or scratches due to wear.

It is found from the study of various conditions of formation of hydrogen-containing amorphous silicon nitride and measurement of the IR that a film free from absorption peaks of Si-H or Si-H$_2$ chains can be formed at a flow ratio of $SiH_4$ : N of 1 : 6 or above, and a radio frequency power of 100 W. It is further found that the amount of N atoms in the hydrogen-containing amorphous silicon nitride film, with which the film is free from Si-H or Si-H$_2$ chain, is determined by the optical band gap and is 2.3 eV or more.

The amorphous silicon nitride film according to the invention may also be obtained using $SiH_4$ and $NH_3$ gases. In this case, since the $NH_3$ gas contains H, the ratio noted above does not hold, and a hydrogen-containing, amorphous silicon nitride film containing a slight amount of H may be formed at a flow ratio of substantially 1 : 1. On the other hand, it is difficult to form a SiC which contains a slight amount of H using $SiH_4$ and $CH_4$ gases.

## Claims

1.  A frictional member comprising:
    a frictional body; and
    a layer, deposited on a frictional surface of said frictional body,
    characterized in that
    said layer is constituted of amorphous silicon containing N and H.

2.  The frictional member according to claim 1, characterized in that said layer is a hydrogen-containing, amorphous silicon nitride film not containing Si-H and Si-H$_2$ chains.

3.  The frictional member according to claim 1, characterized in that said layer is a hydrogen-containing, amorphous silicon nitride film not having an infrared absorption peak of 2,000 to 2,100 cm$^{-1}$, as determined through measurement of infrared absorption.

4.  The frictional member according to claim 1, characterized in that said layer is a hydrogen-containing, amorphous silicon nitride film with an optical band gap of 2.3 eV or above.

5. The frictional member according to claim 1, characterized in that said layer is a hydrogen-containing, amorphous silicon nitride film formed on the surface of said frictional body through glow discharge.

6. A method of surface treating a frictional member, characterized by comprising:
   a first step of introducing a gas containing Si and H and a gas containing N into a housing;
   a second step of causing glow discharge in said housing; and
   a third step of depositing an amorphous silicon film containing N and H on a frictional surface of a body of the frictional member accommodated in said housing from Si, N and H obtained as a result of decomposition through the glow discharge.

7. The method of surface treating according to claim 6, characterized in that in said third step a hydrogen-containing, amorphous silicon nitride film is formed on said frictional surface of the body.

8. The method of surface treating according to claim 7, characterized in that said hydrogen-containing, amorphous silicon nitride film does not contain Si-H and Si-$H_2$ chains.

9. The method of surface treating according to claim 6, characterized in that said gas containing Si and H is $SiH_4$ gas, and said gas containing N is $N_2$ gas.

10. The method of surface treating according to claim 9, characterized in that the flow ratio between said $SiH_4$ and $N_2$ gases in said first step is set to be 1 as the $SiH_4$ gas, versus 6 or above as the $N_2$ gas.

11. A method of surface treating a frictional member, characterized by comprising:
    a first step of introducing a gas containing Si and a gas containing N and H into a housing;
    a second step of causing glow discharge in a housing; and
    a third step of forming an amorphous silicon film containing N and H on a frictional surface of a body of the frictional member accommodated in said housing from Si, N and H obtained as a result of decomposition through the glow discharge.

12. The method of surface treating according to claim 11, characterized in that in said third step a hydrogen-containing, amorphous silicon nitride film is formed on said body.

13. The method of surface treating according to claim 12, characterized in that said hydrogen-containing, amorphous silicon nitride film does not contain Si-H and Si-$H_2$ chains.

14. The method of surface treating according to claim 11, characterized in that said gas containing Si is $SiH_4$ gas and said gas containing N and H is $NH_3$ gas.

**Revendications**

1. Un élément de frottement comprenant :
   un corps de frottement ; et
   une couche, déposée sur une surface de frottement dudit corps de frottement,
   caractérisé en ce que ladite couche est constituée de silicium amorphe contenant de l'azote et de l'hydrogène.

2. L'élément de frottement selon la revendication 1, caractérisé en ce que ladite couche est un film de nitrure de silicium amorphe contenant de l'hydrogène ne contenant pas de chaînes Si-H et Si-$H_2$.

3. L'élément de frottement selon la revendication 1, caractérisé en ce que ladite couche est un film de nitrure de silicium amorphe contenant de l'hydrogène n'ayant pas un pic d'absorption d'infrarouge de 2 000 à 2 100 cm$^{-1}$, déterminé par mesure de l'absorption infrarouge.

4. L'élément de frottement selon la revendication 1, caractérisé en ce que ladite couche est un film de nitrure de silicium amorphe contenant de l'hydrogène ayant une largeur de bande optique de 2,3 eV ou plus.

5. L'élément de frottement selon la revendication 1, caractérisé en ce que ladite couche est un film de nitrure de silicium amorphe contenant de l'hydrogène formé sur la surface dudit corps de frottement par décharge à faible lueur.

6. Une méthode de traitement en surface d'un élément de frottement, caractérisée en ce qu'elle comprend :
   une première étape d'introduction d'un gaz contenant du Si et du H et d'un gaz contenant du N dans une enceinte ;

une seconde étape de formation d'une décharge à faible lueur dans ladite enceinte ; et

une troisième étape de dépôt d'un film de silicium amorphe contenant du N et du H sur une surface de frottement d'un corps de l'élément de frottement logé dans ladite enceinte à partir de Si, N et H, obtenu en tant que résultat de la décomposition par la décharge à faible lueur.

7. La méthode de traitement en surface selon la revendication 6, caractérisée en ce que dans ladite troisième étape un film de nitrure de silicium amorphe contenant de l'hydrogène est formé sur ladite surface de frottement du corps.

8. La méthode de traitement en surface selon la revendication 7, caractérisée en ce que ledit film de nitrure de silicium amorphe contenant de l'hydrogène ne contient pas de chaînes Si-H et Si-H$_2$.

9. La méthode de traitement en surface selon la revendication 6, caractérisée en ce que ledit gaz contenant du Si et du H est du SiH$_4$ gazeux, et ledit gaz contenant du N est du N$_2$ gazeux.

10. La méthode de traitement en surface selon la revendication 9, caractérisée en ce que le rapport de débit entre ledit SiH$_4$ et ledit N$_2$ gazeux dans ladite première étape est réglé à 1 pour le SiH$_4$ gazeux, contre 6 ou plus pour le N$_2$ gazeux.

11. Une méthode de traitement en surface d'un élément de frottement, caractérisée en ce qu'elle comprend :

une première étape d'introduction d'un gaz contenant du Si et d'un gaz contenant du N et du H dans une enceinte ;

une seconde étape de formation d'une décharge à faible lueur dans une enceinte ; et

une troisième étape de formation d'un film de silicium amorphe contenant du N et du H sur une surface de frottement d'un corps d'un élément de frottement logé dans ladite enceinte à partir du Si, N et H, obtenu en tant que résultat de la décomposition par la décharge à faible lueur.

12. La méthode de traitement en surface selon la revendication 11, caractérisée en ce que dans ladite troisième étape, un film de nitrure de silicium amorphe contenant de l'hydrogène est formé sur ledit corps.

13. La méthode de traitement en surface selon la revendication 12, caractérisée en ce que ledit film de nitrure de silicium amorphe contenant de l'hydrogène ne contient pas de chaînes Si-H et Si-H$_2$.

14. La méthode de traitement en surface selon la revendication 11, caractérisée en ce que ledit gaz contenant du Si est le SiH$_4$ gazeux et ledit gaz contenant du N et du H est le NH$_3$ gazeux.

**Ansprüche**

1. Reibungsteil, umfassend einen Reibungskörper und eine auf der Reibungsoberfläche des Reibungskörpers abgelagerte Schicht, dadurch gekennzeichnet, daß die betreffende Schicht aus N- und H-enthaltendem amorphem Silizium besteht.

2. Reibungsteil nach Anspruch 1, dadurch gekennzeichnet, daß die betreffende Schicht aus einem wasserstoffhaltigen amorphen Siliziumnitridfilm ohne Si-H-und Si-H$_2$-Ketten besteht.

3. Reibungsteil nach Anspruch 1, dadurch gekennzeichnet, daß die betreffende Schicht aus einem wasserstoffhaltigen amorphen Siliziumnitridfilm ohne einen durch Infrarotabsorptionsmessung bestimmten Infrarotabsorptionspeak von 2 000 - 2 100 cm$^{-1}$ besteht.

4. Reibungsteil nach Anspruch 1, dadurch gekennzeichnet, daß die betreffende Schicht aus einem wasserstoffhaltigen amorphen Siliziumnitridfilm eines optischen Bandabstands von 2,3 eV oder mehr besteht.

5. Reibungsteil nach Anspruch 1, dadurch gekennzeichnet, daß die betreffende Schicht aus einem auf der Oberfläche des Reibungskörpers durch Glimmentladung gebildeten wasserstoffhaltigen amorphen Siliziumnitridfilm besteht.

6. Verfahren zur Oberflächenbehandlung eines Reibungsteils, gekennzeichnet durch eine erste Stufe, in der ein Si und H und ein N enthaltendes Gas in ein Gehäuse eingeleitet werden; eine zweite Stufe, in der im Gehäuse eine Glimmentladung herbeigeführt wird, und eine dritte Stufe, in der auf einer Reibungsoberfläche eines in dem Gehäuse befindlichen Körpers des Reibungsteils aus durch die Glimmentladungszersetzung gebildetem Si, N und H ein H- und H-haltiger amorpher Siliziumfilm abgelagert wird.

7. Verfahren zur Oberflächenbehandlung nach Anspruch 6, dadurch gekennzeichnet, daß in der dritten Stufe auf der Reibungsoberfläche des Körpers ein wasserstoffhaltiger amorpher Siliziumnitridfilm gebildet wird.

8. Verfahren zur Oberflächenbehandlung nach Anspruch 7, dadurch gekennzeichnet, daß der wasserstoffhaltige amorphe Siliziumnitridfilm keine Si-H- und Si-H$_2$-Ketten enthält.

9. Verfahren zur Oberflächenbehandlung nach Anspruch 6, dadurch gekennzeichnet, daß das Si und H enthaltende Gas aus gasförmigem SiH$_4$ und das N enthaltende Gas aus gasförmigem N$_2$ bestehen.

10. Verfahren zur Oberflächenbehandlung nach Anspruch 9, dadurch gekennzeichnet, daß das Strömungsverhältnis zwischen den SiH$_4$ - und N$_2$-Gasen in der ersten Stufe auf 1 für das gasförmige SiH$_4$ gegen 6 oder darüber des gasförmigen N$_2$ eingestellt wird.

11. Verfahren zur Oberflächenbehandlung eines Reibungsteils, gekennzeichnet durch eine erste Stufe, in der ein Si-haltiges Gas und ein N-und H-haltiges Gas in ein Gehäuse eingeleitet werden; eine zweite Stufe, in der in einem Gehäuse eine Glimmentladung herbeigeführt wird, und eine dritte Stufe, in der auf einer Reibungsoberfläche eines in dem Gehäuse befindlichen Körpers des Reibungsteils aus durch Glimmentladungszersetzung gebildetem Si, N und H ein N- und H-haltiger amorpher Siliziumfilm abgelagert wird.

12. Verfahren zur Oberflächenbehandlung nach Anspruch 11, dadurch gekennzeichnet, daß in der dritten Stufe auf dem Körper ein wasserstoffhaltiger amorpher Siliziumnitridfilm gebildet wird.

13. Verfahren zur Oberflächenbehandlung nach Anspruch 12, dadurch gekennzeichnet, daß der wasserstoffhaltige amorphe Siliziumnitridfilm keine Si-H- und Si-H$_2$-Ketten enthält.

14. Verfahren zur Oberflächenbehandlung nach Anspruch 11, dadurch gekennzeichnet, daß das Si-haltige Gas aus gasförmigem SiH$_4$ und das N- und H-haltige Gas aus gasförmigem NH$_3$ bestehen.

# F I G. 1

F I G.  2

EP 0 184 757 B1

F I G. 3

F I G. 4